# NEUE EUROPÄISCHE PATENTSCHRIFT

(11) **EP 2 525 397 B2**
(45) Veröffentlichungstag und Bekanntmachung des Hinweises auf die Entscheidung über den Einspruch: **08.08.2018**
(45) Hinweis auf die Patenterteilung: 21.10.2015
(21) Anmeldenummer: 12003854.2
(22) Anmeldetag: 16.05.2012
(51) Int. Cl.: H01L 23/057, H01L 23/373, H01L 23/31

(54) **Leistungshalbleiter**
Power semiconductor
Semi-conducteur de puissance

(30) Priorität: 17.05.2011 DE 202011100820 U
(43) Veröffentlichungstag der Anmeldung: 21.11.2012
(73) Patentinhaber: IXYS Semiconductor GmbH, D-68623 Lampertheim (DE)
(72) Erfinder: Zschieschang, Olaf, 68519 Viernheim (DE); Laschek-Enders, Andreas, 64625 Bensheim (DE)
(74) Vertreter: Oppermann, Frank

(56) Entgegenhaltungen:
- WO-A1-2004/090977
- WO-A2-03/071601
- DE-A1- 19 625 240
- DE-A1-102005 061 772
- US-A1- 2010 140 786
- US-B2- 6 960 825
- US-B2- 7 148 562
- US-B2- 7 456 492
- US-B2- 7 508 668
- US-B2- 7 633 758
- US-B2- 7 835 151
- US-B2- 7 957 135
- Presentation: Case study:"Substrate Free Moulded Power Moduld" held by Frank Osterwald at the ECPE workshop "Power Electronics Substrates _Materials, Performance, Processing and Reliability", on June 17 and 18 2010 in Munich, Germany
- Publication "Substrate Free Molded Power Module" published in the Proceedings PCIM Europe 2009 Conference

## Beschreibung

Die Erfindung betrifft eine Anordnung umfassend einen Leistungshalbleiter mit einem Gehäuse und Leistungs- und Steueranschlüssen sowie einen Kühlkörper, auf dem der Leistungshalbleiter montiert ist.

Die oben genannten Leistungshalbleiter, zu den beispielsweise die bekannten IGBT's. zählen, finden beispielsweise in verschiedenen Gebieten der Elektrotechnik, beispielsweise in Antriebssteuereinrichtungen für Elektromotoren Verwendung.

Aus der EP 0 513 410 B1 und DE 196 46 396 C2 sind Leistungshalbleitermodule bekannt, die jeweils ein elektrisch isolierendes Substrat aufweisen, auf dem eine Schaltungsanordnung mit Leistungshalbleiterbauteilen angeordnet ist. Das Substrat bildet den Boden eines Kunststoffgehäuses, das die Schaltungsanordnung umschließt. Die mit der Schaltungsanordnung kontaktierten elektrischen Leistungsanschlüsse der Halbleiterbauteile erstrecken sich durch das Gehäuse nach außen. Das Gehäuse ist zum Schutz der Schaltungsanordnung mit Vergussmasse gefüllt. Befestigungspunkte am Gehäuse dienen der Verschraubung des Moduls mit einem Kühlkörper.

Die EP 1 976 358 B1 beschreibt einen Leistungshalbleiter, der eine Trägerplatte aus einem isolierenden Keramiksubstrat aufweist, die den Boden des Gehäuses bildet. Die Trägerplatte ist an der Ober- und Unterseite mit einer Metallschicht versehen, wobei die obere Metallschicht zur Bildung von Leiterbahnen strukturiert ist. Mit den Leiterbahnen sind ein Leistungshalbleiterbauteil und die Leistungs- und Steueranschlüsse des Halbleiterbauteils elektrisch verbunden. Die Leistungs- und Steueranschlüsse sind aus dem Gehäuse seitlich herausgeführt. Die Leistungs- und Steueranschlüsse des Leistungshalbleiters sind als Anschlüsse eines oberflächenmontierten Bauteils ausgebildet, das auch als SMD (Surface-Mounted Device) bezeichnet wird. Das SMD-Bauteil wird auf einer Leiterplatte montiert.

Zur Einhaltung der für den elektrischen Betrieb geforderten Isolationsabstände für Luft- und Kriechstrecken zwischen den innerhalb des Gehäuses liegenden Abschnitten der Leistungs- und Steueranschlüsse und der Trägerplatte und zwischen den außerhalb des Gehäuses liegenden Abschnitten der Leistungs- und Steueranschlüsse und der Leiterplatte sind die Leistungs- und Steueranschlüsse derart ausgebildet, dass sich die Anschlüsse innerhalb des Gehäuses zunächst senkrecht von der Trägerplatte weg, dann seitlich durch das Gehäuses nach außen und schließlich senkrecht zur Leiterplatte erstrecken. Dabei haben sämtliche Leistungs- und Steueranschlüsse den gleichen Abstand.

Die DE 196 25 240 A1 beschreibt eine Halbleitervorrichtung, die einen Leiterrahmen aufweist, an den Gruppen von Leistungs- und Steueranschlüssen angeschlossen sind.

Aus der WO 2004/090977 A1 ist eine Halbleitervorrichtung bekannt, bei der Anschlusselemente unterschiedlicher Breite an einander gegenüberliegenden Seiten aus dem Gehäuse herausgeführt sind. Zur Verringerung der Induktivität wird vorgeschlagen, die Stromanschlüsse unmittelbar nebeneinander anzuordnen, wobei die stromführenden Leiterbahnen keine Leiterschleifen bilden sollen.

Die US 2010/0140786 A1 beschreibt ein Halbleitermodul mit Leistungs- und Steueranschlüssen an gegenüberliegenden Seiten des Gehäuses, wobei die Steueranschlüsse von mehreren Bauteilen aber nicht jeweils zur Gruppen zusammengefasst sind, die auf einer Gehäuseseite im Abstand zueinander angeordnete Reihen von Anschlüssen bilden.

Die WO 03/071601 A2 beschreibt einen Leistungshalbleiter mit einer Trägerplatte, die in drei Abschnitte getrennt ist. Auf jedem Trägerabschnitt befindet sich eine Leistungsdiode und ein Leistungstransistor. Die Stromversorgung der Dioden und der Transistoren und die Übertragung von Steuersignalen an das Schaltungsmodul erfolgt mit Flachleitern, die an der Seite aus dem Gehäuse des Moduls herausgeführt sind. Die schmaleren Flachleiter für die Übertragung der Signale befinden sich auf der einen Längsseite des Gehäuses. Die schmalen Flachleiter sind jeweils in Gruppen von fünf Leitern unterteilt, die jeweils einem der Trägerabschnitte zugeordnet sind.

Der Erfindung liegt die Aufgabe zugrunde, einen Leistungshalbleiter mit verbesserten technischen Eigenschaften bereitzustellen.

Diese Aufgabe wird erfindungsgemäß mit den im Patentanspruch 1 angegebenen Merkmalen gelöst. Die Unteransprüche beziehen sich auf bevorzugte Ausführungsformen der Erfindung.

Der erfindungsgemäße Leistungshalbleiter verfügt über eine Trägerplatte, auf der zwei Leistungshalbleiterbauteile angeordnet sind. Die Trägerplatte mit den zwei Leistungshalbleiterbauteilen wird zumindest teilweise von einem Gehäuse umschlossen. Mit dem mindestens einen Leistungshalbleiterbauteil sind Leistungs- und Steueranschlüssen elektrisch verbunden, die aus dem Gehäuse herausgeführt sind.

Der erfindungsgemäße Leistungshalbleiter zeichnet sich dadurch aus, dass die Leistungsanschlüsse auf der einen Seite des Gehäuses in einer Reihe angeordnet sind und die Steueranschlüsse auf der anderen Seite des Gehäuses in einer Reihe angeordnet sind, wobei der Abstand zwischen nebeneinander liegenden Leistungsanschlüssen größer als der Abstand zwischen nebeneinander liegenden Steueranschlüssen ist. Aus der besonderen Anordnung der Leistungs- und Steueranschlüsse auf den beiden Seiten des Gehäuses ergeben sich verbesserte elektrische Eigenschaften insbesondere bei der Anwendung mit hohen Spannungen und Strömen, da die Isolationsabstände für Luft- und Kriechstrecken größer als bei den bekannten Leistungshalbleitern sind.

Bei einer bevorzugten Ausführungsform weisen die Leistungsanschlüsse einen größeren Querschnitt als die Steueranschlüsse auf, so dass der Leistungshalbleiter zum Schalten von hohen Strömen geeignet ist.

Neben der obigen Anordnung der Leistungs- und Steueranschlüsse werden kritische Luft- oder Kriechstrecken durch die besondere Ausbildung der Anschlüsse selbst vermieden. Die Leistungs- und Steueranschlüsse weisen einen ersten Abschnitt auf, der sich seitlich aus dem Gehäuse erstreckt, einen zweiten Abschnitt auf, der sich von dem ersten Abschnitt zu der Leiterplatte erstreckt, und einen dritten Abschnitt auf, der sich von dem zweiten Abschnitt seitlich nach außen erstreckt. Die einzelnen Abschnitte schließen einen Winkel ein, der 90° beträgt.

Die Erfindung sieht eine Anordnung von zwei Leistungshalbleiterbauteilen auf der Trägerplatte vor. Dabei weisen die Leistungshalbleiterbauteile gemeinsame Leistungsanschlüsse auf, die auf der einen Seite des Gehäuses angeordnet sind und getrennte Steueranschlüsse auf, die auf der anderen Seite des Gehäuses angeordnet sind. Die dem ersten Leistungshalbleiterbauteil zugeordneten Steueranschlüsse sind in einer ersten Reihe des Gehäuses nebeneinander angeordnet sind und die dem zweiten Leistungshalbleiterbauteil zugeordneten Steueranschlüsse sind in einer zweiten Reihe nebeneinander angeordnet. Vorzugsweise ist der Abstand zwischen der ersten Reihe und der zweiten Reihe von Steueranschlüssen größer als der Abstand zwischen benachbarten Steueranschlüssen in der ersten und zweiten Reihe. Mit dieser besonders bevorzugten Anordnung werden die Steueranschlüssen in einzelne Gruppen unterteilt, wobei jede Gruppe von Anschlüssen nur einem Leistungshalbleiter zugeordnet ist. Damit wird sichergestellt, dass die Steueranschlüsse unterschiedlicher Gruppen, die sich im Hinblick auf das elektrische Potential stärker voneinander unterscheiden können, in einem ausreichenden Isolationsabstand angeordnet sind, während die Steueranschlüsse einer Gruppe, die sich im Hinblick auf das Potential weniger voneinander unterscheiden können, dichter nebeneinander angeordnet sind. Der Abstand zwischen der ersten Reihe und der zweiten Reihe von Steueranschlüssen kann dem Abstand zwischen benachbarten Leistungsanschlüssen entsprechen oder kleiner sein.

Für die Erfindung ist es grundsätzlich unerheblich, um welche Bauteile es sich bei den Leistungshalbleitermodulen handelt. Die Leistungshalleitermodule können beispielsweise IGBT's, aber auch MOSFET's oder andere bekannte Leistungshalbleiterbauteile sein.

Für die Montage auf einem Kühlkörper schließt die dem Kühlkörper zugewandte Seite des Trägers bündig mit dem Gehäuse ab.

Im Folgenden wird ein Ausführungsbeispiel der Erfindung unter Bezugnahme auf die Figuren näher erläutert.

Es zeigen:
- Fig. 1: ein Ausführungsbeispiel des erfindungsgemäßen Leistungshalbleiters in perspektivischer Darstellung in der Rückansicht und
- Fig. 2: den Leistungshalbleiter von Fig. 1 in der Draufsicht.

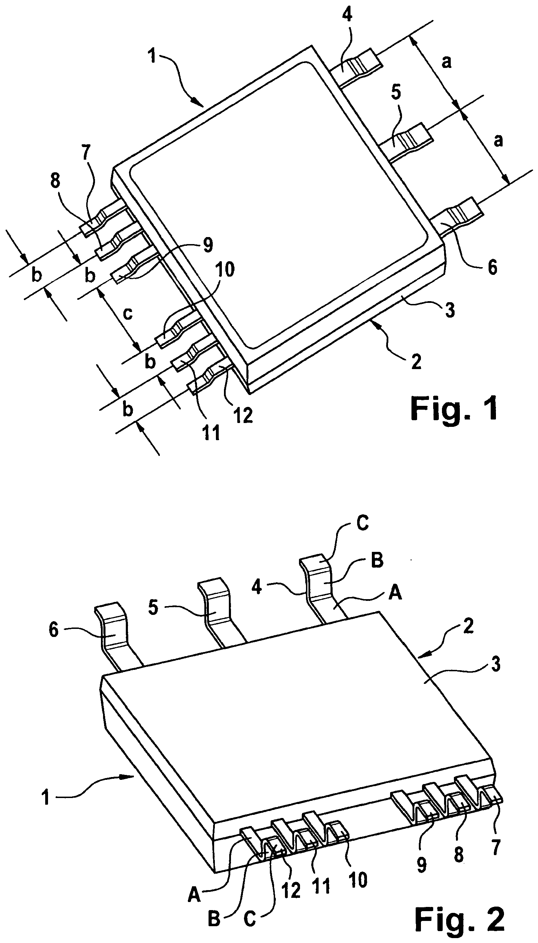

Das erfindungsgemäße Leistungshalbleiterbauelement weist ein Gehäuse 1 auf, das vorzugsweise aus einem isolierenden Material, beispielsweise aus einer Epoxidmasse besteht. Das Gehäuse 1 kann aber auch zumindest teilweise aus Metall gefertigt sein. Die Figuren 1 und 2 zeigen das Gehäuse des Leistungshalbleiters aus unterschiedlichen Ansichten. Da Leistungshalbleiter als solche bekannt sind, wird auf die Darstellung der Leistungshalbeiterbauteile und ihre Kontaktierung im Inneren des Gehäuses verzichtet. Bei dem vorliegenden Ausführungsbeispiel hat das rechtwinklige flache Gehäuse die Abmessungen von 25 mm x 23 mm x 5,5 mm.

Das Gehäuse 1 schließt teilweise eine Trägerplatte 2 aus einem isolierenden Keramiksubstrat ein, wobei die Trägerplatte 2 den Boden 3 des Gehäuses 1 bildet. Die Trägerplatte 2 ist sowohl auf ihrer dem Gehäuse zugewandten Seite als auch auf ihrer dem Gehäuse abgewandten Seite mit einer Metallschicht versehen, wobei die dem Gehäuse zugewandte Metallschicht entsprechend den Leiterbahnen einer Schaltungsanordnung strukturiert ist. Auf dieser strukturierten Metallschicht sind bei dem vorliegenden Ausführungsbeispiel zwei in den Figuren nicht dargestellte Leistungshalbleiterbauteile, beispielsweise IGBT's angeordnet. Die Leistungshalbleiterbauteile können an der Unterseite mit der strukturierten Metallschicht verlötet sein. An der Oberseite sind die Leistungshalbleiterbauteile mittels nicht dargestellten Bonddrähten mit den Leiterbahnen der strukturierten Metallschicht elektrisch verbunden, wobei die Enden der Bonddrähte jeweils mit den Leistungshalbleiterbauteilen und den Leiterbahnen verlötet sind. Der Leistungshalbleiter wird auf einen nicht dargestellten Kühlkörper montiert, wobei der Gehäuseboden 3 auf dem Kühlkörper aufliegt.

Beide Leistungshalbleitermodule verfügen über Leistungsanschlüsse 4, 5, 6 und Steueranschlüsse 7, 8, 9, 10, 11, 12. Die Leistungsanschlüsse 4, 5, 6 beider Leistungshalbleiterbauteile sind bei dem vorliegenden Ausführungsbeispiel zu drei gemeinsamen Leistungsanschlüssen zusammengefasst, die aus dem Gehäuse 1 seitlich herausgeführt sind. Die beiden Leistungshalbleiterbauteile haben jedoch jeweils drei getrennte Steueranschlüsse 7, 8, 9 bzw. 10, 11, 12, die ebenfalls aus dem Gehäuse 1 herausgeführt sind.

Die Leistungs- und Steueranschlüsse 4 bis 12 sind laschenförmig ausgebildete Anschlüsse, die als Anschlüsse eines oberflächenmontierten Bauteils, d.h. eines SMD Bauteils (**S**urface-**M**ounted **D**evice) ausgebildet sind. Sämtliche Anschlüsse weisen einen ersten Abschnitt A auf, der sich seitlich nach außen aus dem Gehäuse 1 heraus erstreckt. An den ersten Abschnitt A schließt sich ein zweiter zur nicht dargestellten Leiterplatte weisender Abschnitt B an, der mit dem ersten Abschnitt einen Winkel von etwa 90° einschließt. Der zweite Abschnitt B geht in einen nach außen weisenden dritten Abschnitt C über, der mit dem zweiten Abschnitt B wieder einen Winkel von etwa 90° einschließt. Der dritte Abschnitt jedes Anschlusses wird elektrisch mit der nicht dargestellten Leiterplatte verbunden. Die Leistungs- und Steueranschlüsse 4 bis 12 unterscheiden sich in ihrem Querschnitt, wobei die Leistungsanschlüsse 4, 5, 6 einen größeren Querschnitt als die Steueranschlüsse 7, 8, 9, 10, 11, 12 aufweisen.

Die Leistungsanschlüsse 4, 5, 6 sind in einer Reihe in gleichbleibenden Abständen a auf der einen Längsseite des Gehäuses angeordnet, während die benachbarten Steueranschlüsse 7, 8, 9, 10, 11, 12 in einer Reihe auf der anderen Längsseite des Gehäuses in einem Abstand b angeordnet sind. Der Abstand a zwischen den benachbarten Leistungsanschlüssen 4, 5, 6 ist dabei größer als der Abstand der äußeren Leistungsanschlüsse und den Rändern des Gehäuses. Die benachbarten Steueranschlüsse 7, 8, 9, 10, 11, 12 beider Leistungshalbleiterbauteile bilden eine erste Gruppe 7, 8, 9 und eine zweite Gruppe 10, 11, 12, die auf der anderen Längsseite des Gehäuses 1 in einem Abstand c nebeneinander angeordnet sind, der größer als der Abstand b zwischen den benachbarten Steueranschlüssen 4, 5, 6 einer Gruppe ist. Dabei entspricht der Abstand c dem Abstand a oder ist kleiner als der Abstand a. Sowohl mit der besonderen Anordnung als auch der besonderen Ausbildung der Leistungs- und Steueranschlüsse werden für den elektrischen Betrieb bei hohen Spannungen und Strömen ausreichende Luft- und Kriechstrecken geschaffen, so dass die elektrischen Eigenschaften des Halbleiterbauteils verbessert sind.

## Patentansprüche

1. Anordnung umfassend einen Leistungshalbleiter und einen Kühlkörper, auf dem der Leistungshalbleiter montiert ist, wobei
der Leistungshalbleiter eine Trägerplatte (2) aufweist, auf der zwei Leistungshalbleiterbauteile angeordnet sind, und ein Gehäuse (1) aufweist, das die Trägerplatte mit den Leistungshalbleiterbauteilen zumindest teilweise umschließt,
die Trägerplatte (2) aus einem den Boden des Gehäuses (1) bildenden isolierenden Keramiksubstrat besteht, das sowohl auf der dem Gehäuse (1) zugewandten Seite als auch der dem Gehäuse (1) abgewandten Seite mit einer Metallschicht versehen ist, und die dem Gehäuse (1) zugewandte Metallschicht zu Leiterbahnen strukturiert ist und die dem Kühlkörper zugewandte Seite der Trägerplatte (2) bündig mit dem Gehäuse (1) abschließt und der Gehäuseboden (3) auf dem Kühlkörper aufliegt,
die beiden Leistungshalbleiterbauteile mit aus dem Gehäuse (1) herausgeführten Leistungsanschlüssen (4, 5, 6) und Steueranschlüssen (7, 8, 9, 10, 11, 12) elektrisch verbunden sind, die laschenförmig ausgebildete Anschlüsse sind und einen ersten Abschnitt (A) aufweisen, der sich seitlich aus dem Gehäuse (1) erstreckt, einen zweiten Abschnitt (B) aufweisen, der sich von dem ersten Abschnitt zu der Leiterplatte erstreckt, und einen dritten Abschnitt (C) aufweisen, der sich von dem zweiten Abschnitt seitlich nach außen erstreckt, wobei die einzelnen Abschnitte (A, B, C) einen Winkel von 90° einschließen,
sämtliche Leistungsanschlüsse (4, 5, 6) der beiden auf der Trägerplatte angeordneten Leistungshalbleiterbauteile auf der einen Seite des Gehäuses (1) aus dem Gehäuse herausgeführt und in einer Reihe angeordnet sind und sämtliche Steueranschlüsse (7, 8, 9, 10, 11, 12) der beiden Leistungshalbleiterbauteile auf der gegenüberliegenden Seite des Gehäuses (1) aus dem Gehäuse herausgeführt und in einer Reihe angeordnet sind, wobei der Abstand (a) zwischen nebeneinander liegenden Leistungsanschlüssen (4, 5, 6) größer als der Abstand (b) zwischen nebeneinander liegenden Steueranschlüssen (7, 8, 9 bzw. 10, 11, 12) ist, und
die Leistungshalbleiterbauteile gemeinsame Leistungsanschlüsse (4, 5, 6) aufweisen, die auf der einen Seite des Gehäuses (1) angeordnet sind und getrennte Steueranschlüsse (7, 8, 9, 10, 11, 12) aufweisen, von denen die dem ersten Leistungshalbleiterbauteil zugeordneten Steueranschlüsse (7, 8, 9) in einer ersten Reihe auf der anderen Seite des Gehäuses nebeneinander angeordnet sind und die dem zweiten Leistungshalbleiterbauteil zugeordneten Steueranschlüsse (10, 11, 12) in einer zweiten Reihe auf der anderen Seite des Gehäuses nebeneinander angeordnet sind.

2. Leistungshalbleiter nach Anspruch 1, **dadurch gekennzeichnet, dass** die Leistungsanschlüsse (4, 5, 6) einen größeren Querschnitt als die Steueranschlüsse (7, 8, 9, 10, 11, 12) des Leistungshalbleiterbauteils aufweisen.

3. Leistungshalbleiter nach Anspruch 1 oder 2, **dadurch gekennzeichnet, dass** der Abstand (c) zwischen der ersten Reihe und der zweiten Reihe von Steueranschlüssen (7, 8, 9, 10, 11, 12) größer als der Abstand (b) zwischen den Steueranschlüssen 7, 8, 9 bzw. 10, 11, 12) in der ersten und zweiten Reihe ist.

4. Leistungshalbleiter nach Anspruch 3, **dadurch gekennzeichnet, dass** der Abstand (c) zwischen der ersten Reihe und der zweiten Reihe von Steueranschlüssen (7, 8, 9, 10, 11, 12) dem Abstand (a) zwischen den Leistungsanschlüssen entspricht.

5. Leistungshalbleiter nach einem der Ansprüche 1 bis 4, **dadurch gekennzeichnet, dass** das mindestens eine Leistungshalbleiterbauteil ein IGBT ist.

## Claims

1. Arrangement including a power semiconductor and a heat dissipating body on which the power semiconductor is mounted, whereby
the power semiconductor comprises a support plate (2), on which two semiconductor components are arranged, and a housing (1) which encloses the support plate comprising the power semiconductor components at least in part,
the support plate (2) consists of an insulating ceramic substrate which forms the base of the housing (1) and is provided both on the side facing the housing (1) and on the side remote from the housing (1) with a metal coating, and the metal coating facing the housing (1) is structured according to conductor tracks and the side of the support plate (2) facing the heat dissipating body ends flush with the housing (1) and the base (3) of the housing lies on the heat dissipating body,
both power semiconductor components are electrically connected to power connections (4, 5, 6) and the control connections (7, 8, 9, 10, 11, 12) extending laterally out of the housing (1), which are bracket-shaped connections and which comprise a first portion (A) which extends laterally out of the housing (1), comprise a second portion (B) which extends from the first portion to the circuit board, and comprise a third portion (C) which extends laterally outwards from the second portion, the individual portions (A, B, C) subtending an angle of 90°,
all the power connections (4, 5, 6) of both power semiconductor components arranged on the support plate are led out of the housing on one side of the housing (1) and arranged in a row, and all the control connections (7, 8, 9, 10, 11, 12) of both power semiconductor components are led out of the housing on the opposite side of the housing (1) and arranged in a row, the spacing (a) between adjacent power connections (4, 5, 6) being greater than the spacing (b) between adjacent control connections (7, 8, 9 and 10, 11, 12 respectively), and
the power semiconductor components comprise common power connections (4, 5, 6) which are arranged on one side of the housing (1) and comprise separate control connections (7, 8, 9, 10, 11, 12), the control connections (7, 8, 9) associated with the first power semiconductor component being arranged beside one another in a first row on the other side of the housing and the control connections (10, 11, 12) associated with the second power semiconductor component being arranged beside one another in a second row on the other side of the housing.

2. Power semiconductor according to claim 1, **characterised in that** the power connections (4, 5, 6) have a larger cross section than the control connections (7, 8, 9, 10, 11, 12) of the power semiconductor component.

3. Power semiconductor according to claim 1 or 2, **characterised in that** the spacing (c) between the first row and the second row of control connections (7, 8, 9, 10, 11, 12) is greater than the spacing (b) between the control connections (7, 8, 9 and 10, 11, 12 respectively) in the first and second row.

4. Power semiconductor according to claim 3, **characterised in that** the spacing (c) between the first row and the second row of control connections (7, 8, 9, 10, 11, 12) corresponds to the spacing (a) between the power connections.

5. Power semiconductor according to any of claims 1 to 4, **characterised in that** the at least one power semiconductor component is an IGBT.

## Revendications

1. Agencement comprenant un semi-conducteur de puissance et un corps de refroidissement, sur lequel est monté le semi-conducteur de puissance, dans lequel le semi-conducteur de puissance comprend une plaque porteuse (2), sur laquelle sont disposés deux parties de construction de semi-conducteur de puissance, et un boîtier (1), qui entoure au moins partiellement la plaque porteuse avec les parties de construction de semi-conducteur de puissance,
la plaque porteuse (2) est constituée d'un substrat isolant en céramique formant le fond du boîtier (1), qui est pourvu d'une couche métallique non seulement sur la face tournée vers le boîtier (1) mais aussi sur la face opposée au boîtier (1), et la couche métallique tournée vers le boîtier (1) est structurée en pistes conductrices et la face tournée vers le corps de refroidissement de la plaque porteuse (2) se termine à fleur du boîtier (1) et le fond de boîtier (3) repose sur le corps de refroidissement,
les deux parties de construction de semi-conducteur de puissance sont reliées électriquement avec des raccords de puissance (4, 5, 6) et de commande (7, 8, 9, 10, 11, 12), dépassant du boîtier (1), qui sont des raccords réalisés en forme de languette et présentent une première partie (A) qui s'étend latéralement hors du boîtier (1), présentent une deuxième partie (B) qui s'étend à partir de la première partie jusqu'à la plaque conductrice, et présentent une troisième partie (C) qui s'étend à partir de la deuxième partie latéralement vers l'extérieur, dans lequel les parties individuelles (A, B, C) forment un angle de 90°,
tous les raccords de puissance (4, 5, 6) des deux parties de construction de semi-conducteur de puissance disposés sur la plaque porteuse dépassent hors du boîtier d'un côté du boîtier (1) et sont disposés en un rang et tous les raccords de commande (7, 8, 9, 10, 11, 12) des deux parties de construction de semi-conducteur de puissance dépassent hors du boîtier du côté opposé du boîtier (1) et sont disposés en un rang, dans lequel la distance (a) entre les raccords de puissance (4, 5, 6) se trouvant côte-à-côte est supérieure à la distance (b) entre les raccords de commande (7, 8, 9 ou 10, 11, 12) se trouvant côte-à-côte, et
les parties de construction de semi-conducteur de puissance présentent des raccords de puissance (4, 5, 6) communs qui sont disposés d'un côté du boîtier (1) et des raccords de commande (7, 8, 9, 10, 11, 12) distincts, dont les raccords de commande (7, 8, 9) associés à la première partie de construction de semi-conducteur de puissance sont disposés côte-à-côte en un premier rang de l'autre côté du boîtier et les raccords de commande (10, 11, 12) associés à la seconde partie de construction de semi-conducteur de puissance sont agencés côte-à-côte en un second rang de l'autre côté du boîtier.

2. Semi-conducteur de puissance selon la revendication 1, **caractérisé en ce que** les raccords de puissance (4, 5, 6) présentent une section transversale supérieure aux raccords de commande (7, 8, 9, 10, 11, 12) de la partie de construction de semi-conducteur de puissance.

3. Semi-conducteur de puissance selon la revendication 1 ou 2, **caractérisé en ce que** la distance (c) entre le premier rang et le second rang de raccords de commande (7, 8, 9, 10, 11, 12) est supérieure à la distance (b) entre les raccords de commande (7, 8, 9 ou 10, 11, 12) du premier et du second rang.

4. Semi-conducteur de puissance selon la revendication 3, **caractérisé en ce que** la distance (c) entre le premier rang et le second rang de raccords de commande (7, 8, 9, 10, 11, 12) correspond à la distance (a) entre les raccords de puissance.

5. Semi-conducteur de puissance selon l'une quelconque des revendications 1 à 4, **caractérisé en ce que** l'au moins un des éléments de semi-conducteur de puissance est un IGBT.
